# EUROPEAN PATENT APPLICATION

(11) **EP 4 468 358 A1**
(43) Date of publication of application: **27.11.2024**
(21) Application number: 23175174.4
(22) Date of filing: 24.05.2023
(51) Int. Cl.: H01L 27/144, H01L 31/107, H01L 31/0232, G01S 17/00

(54) **PHOTOSENSITVE ELEMENT AND ASSEMBLY METHOD THEREOF**

(71) Applicant: First Sensor AG, 12459 Berlin (DE)
(72) Inventor: SABRI ALIREZAEI, Iman, 12459 Berlin (DE); WILKE, Martin, 12459 Berlin (DE); CHAVEZ, Ruben, 12459 Berlin (DE); SCHILLGALIES, Ruben, 12459 Berlin (DE)
(74) Representative: Grünecker Patent- und Rechtsanwälte PartG mbB

(57) **Abstract**

The present invention relates to a photosensitive element comprising a semiconductor substrate with a radiation receiving area through which incident radiation can enter the photosensitive element. Further, the photosensitive element comprises a first contact region connected to a first contact and a second contact region connected to a second contact. A multiplication region for multiplying generated carriers under the incident radiation is formed at the first contact region when a voltage is applied between the first contact and the second contact. The first contact and the second contact are arranged on the side opposite to the radiation receiving area of the semiconductor substrate. Further, a radiation reflecting area is disposed on the side opposite to the radiation receiving area of the semiconductor substrate. Further, the present invention relates to an assembly method to provide a photosensitive element.

## Description

The present disclosure relates to a photosensitive element and an assembly method providing the photosensitive element.

Photosensitive elements such as photodiodes are widely used to convert radiation into electrical signals. Thereby, the radiation enters the photodiode, is absorbed and a current is produced.

Such photosensitive elements are known in the field of safety devices for industrial automation and automotive applications. In particular, LIDAR (light detection and ranging) technology will be used in advanced driver-assistance systems (ADAS) and is the key technology for enabling autonomous driving. In these LIDAR systems, there are different detector styles used which are based on different photosensitive elements. One type of photosensitive elements are avalanche photodiodes (APDs).

APDs are semiconductor elements, which may be based on silicon and have a very compact size, high quantum efficiency and relatively high gain. The internal structure of an APD is made of an intrinsic or lightly doped p-type semiconductor, with heavily doped p and n-type regions that are in contact with the cathode and the anode. By using a highly doped region and a deep lightly doped region in silicon crystal, a very high internal field is maintained across the p-n-junction which produces a high internal gain. Through these metal contacts, an external high reverse bias voltage is supplied. When radiation enters the APD, the high internal field causes the avalanche effect of multiplying generated electron-hole pairs and causing an electrical signal at the output.

Common APD are fabricated using a complementary metal-oxide-semiconductor (CMOS) process with a p-doped epi-layer arranged over a highly doped p-type substrate. The anode is connected to the highly doped p-type substrate and on the opposite side of the APD the cathode is arranged. In operation, the radiation enters the APD at the cathode's side (front side) and the internal structure of the APD causes a flow of generated charges between the cathode and the anode. These APDs are wire-bonded to a corresponding carrier.

Such a CMOS fabricated single-photon avalanche diode (SPAD) is proposed by G. Paternoster et al. in their contribution to the 16th (Virtual) Trento workshop on Advanced Silicon Radiation Detects held on February 16-18, 2021 (https://indico.cern.ch/event/983068/contributions/4223039/attachments/2191308/3703680/TRE DI21 Paternoster.pdf - retrieved on March 2, 2023). Therein, a backside illuminated SPAD is proposed, which has one metal contact (cathode) arranged on the top side of the SPAD and another metal contact (anode) arranged on the bottom side of the SPAD. Radiation enters the SPAD from the bottom side. The charge that is generated in silicon flows vertically through the SPAD between the anode and the cathode.

One drawback of the current solutions is that the sensitivity and fill factor of the front-side illuminated APD is limited due to the wire-bonding of the APD. Further, due to the thick epi-layer for near infrared spectral range a trade-off between the requirements on the sensitivity and the speed of the APD has to be found.

It is therefore an object of the present invention to provide an improved photosensitive element with a reduced size and an improved sensitivity and speed in order to overcome the disadvantages of the conventional technologies.

This object is solved by the subject-matter of the independent claims. Advantageous examples of the present disclosure are the subject-matter of the dependent claims.

The present disclosure is based on the idea that the sensitivity and speed of the APD also for radiation of long wavelengths can be increased by improving the structure of the APD.

In particular, a photosensitive element comprises a semiconductor substrate with a radiation receiving area through which incident radiation can enter the photosensitive element. Further, the photosensitive element comprises a first contact region connected to a first contact and a second contact region connected to a second contact. A multiplication region for multiplying charges generated from the incident radiation is formed at the first contact region when a voltage is applied between the first contact and the second contact. The first contact and the second contact are arranged on the side opposite to the radiation receiving area of the semiconductor substrate. Further, a radiation reflecting area is disposed on the side opposite to the radiation receiving area of the semiconductor substrate.

The use of a radiation reflecting area that reflects the incident radiation doubles the effective distance the radiation entails in the semiconductor substrate. This advantageously increases the probability that the radiation, also referred to as light, will be absorbed in the substrate. This is of particular interest because electromagnetic energy has different absorption depths depending on its wavelength. Long wavelengths in the red and infrared range are absorbed deep in the substrate. When mirroring the incident ray, long wavelengths can be absorbed while at the same time the thickness of the substrate can advantageously be reduced. Reducing the thickness of the substrate advantageously improves the speed and the sensitivity of the photosensitive element.

A radiation reflecting area according to the present disclosure might be any area of different size that can be used to reflect a radiation of various wavelength. Thereby, the present invention is not limited to any certain specific reflective material, but might be any reflective material. The material that is used might be chosen depending on the radiation wavelength that is to be reflected, making the present invention applicable for a various number of applications.

The radiation receiving area of the present invention is preferably made from a metal-free material.

According to an advantageous further development of the present disclosure, the first contact region of the photosensitive element comprises regions of different conductivity of a first conductivity type and the second contact region comprises regions of different conductivity of a second conductivity type.

According to an advantageous further development of the present disclosure, the first contact region comprises a highly doped first region of the first conductivity type disposed above a first well of the first conductivity type. Further, a second region of the first conductivity type is disposed radially outwards to the first region and the first well.

According to an advantageous further development of the present disclosure, the second contact region comprises a highly doped third region of the second conductivity type disposed above a second well of the second conductivity type.

Advantageously, the semiconductor substrate is a p-type substrate and the first conductivity type is an n-type and the second conductivity is a p-type.

According to an advantageous further development of the present disclosure, the second contact region is at least partly surrounded by a trench, with the trench comprising a doped sidewall of the second conductivity type. The trench advantageously provides a low path resistance and reduces the potential of dark noises. The trench comprising a doped sidewall can increase the charge transfer efficiency. Preferably, the depth of shallow doping of the second conductivity type on the trench side walls increases with a depth of the trench. Alternatively, the doping concentration on the trench side walls is substantially uniform at different depths of the trench.

According to an advantageous further development of the present disclosure, the radiation reflecting area has a diameter D of 230 µm.

According to an advantageous further development of the present disclosure, an anti-reflective coating (ARC) or a Bragg filter is arranged below the semiconductor substrate at the radiation receiving area. The anti-reflective coating advantageously improves the radiation transmission properties of the radiation receiving area. Further, an ARC can be used to improve or control the absorption characteristics of the semiconductor substrate at a desired wavelength. The properties of the ARC can be advantageously chosen depending on the wavelength that is of interest.

According to an advantageous further development of the present disclosure, a highly doped fourth region of the second conductivity type is arranged between the semiconductor substrate and the anti-reflective coating or the Bragg filter. The region advantageously increases the charge transfer efficiency to the multiplication region.

According to an advantageous further development of the present disclosure, the semiconductor substrate comprises silicon. Using a thin layer of silicon has the positive effect that the breakdown voltage can be reduced.

According to an advantageous further development of the present disclosure, the photosensitive element is a linear mode avalanche photodiode fabricated on bipolar technology. The fabrication of the photosensitive element based on bipolar technology uses a silicon substrate, which advantageously makes the use of a thick epitaxial (EPI) layer unnecessary. This advantageously overcomes the drawback of previous solutions using the EPI layer that a trade-off between the sensitivity and the speed of the photosensitive element has to be found.

According to an advantageous further development of the present disclosure, the radiation reflecting area comprises metal and/or metal alloy.

According to an advantageous further development of the present disclosure, the semiconductor substrate has a depth that is less than a total absorption depth of wavelength in the red - infrared spectrum. The particularly short depth of the substrate reduces the package size of the photosensitive element. At the same time, the idea of the using a radiation reflecting area enables that these wavelengths can nevertheless be absorbed in the thin substrate.

According to an advantageous further development of the present disclosure, the third well of the second conductivity type is arranged below the first contact region and completely surrounded by the semiconductor substrate.

According to an advantageous further development of the present disclosure, the photosensitive element has a sensitivity of above 70 % (A/W) at a spectral range of 800 nm - 930 nm. In particular, the photosensitive element has advantageously a peak sensitivity of 73 % (A/W) at a wavelength of 905 nm. The term sensitivity in this context relates to the amount to which an object reacts upon receiving photons. Exemplarily the sensitivity value can be reached with a thickness of the semiconductor substrate of 30 µm.

The present invention further relates to an assembly method providing a photosensitive element according to an advantageous development of the present disclosure and further comprises the steps of:
Assembling the photosensitive element on a carrier, with the carrier being arranged on the side opposite to the radiation receiving area of the photosensitive element.

The advantageous structure of the photosensitive element enables that the element can be assembled on the carrier via flip-chip bonding. This assembly method improves the reliability and reduces the package size of the element. Further, the assembled photosensitive element can be easily integrated into existing solutions and further processed. Using a flip-chip bonding instead of the standard wire bonding assembly method also has advantageous effects on the signal-to-noise ratio (SNR) and the fill factor of the photosensitive element.

To better understand the present disclosure, this is explained in greater detail using the example depicted in the following Figures. Identical parts are hereby provided with identical reference numbers and identical component names. Furthermore, some features or combinations of features from the various examples shown and described may also represent independent solutions, inventive solutions or solutions according to the disclosure. In the drawings:
- **Fig. 1**: shows a photosensitive element according to the present disclosure,
- **Fig. 2**: shows the layout of the photosensitive element according to the present disclosure,
- **Fig. 3**: shows an assembled photosensitive element according to the present disclosure.

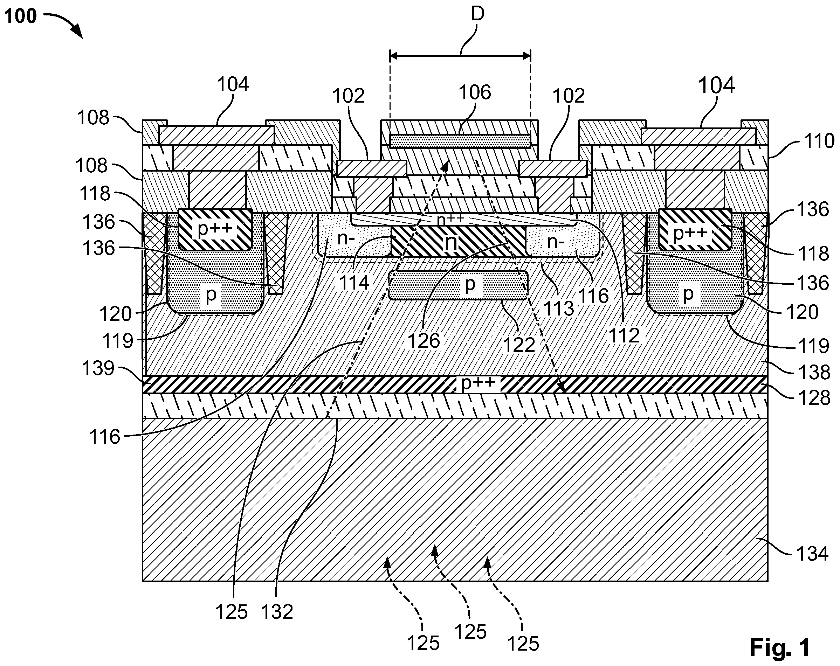

Further, preferred aspects of the present invention are described with respect to Figure 1.

Figure 1 shows the photosensitive element 100 according to the present disclosure. The photosensitive element 100 comprises a semiconductor substrate 138 with a first contact region 113 and a second contact region 119. The first contact region 113 comprises regions of different conductivity of a first conductivity type and the second contact region 119 comprises regions of different conductivity of a second conductivity type.

The first contact region 113 is connected to a first contact 102 and the second contact region 119 is connected to a second contact 104. Preferably, the first contact 102 is described as the cathode and the second contact 104 is described as the anode of the photosensitive element 100. Preferably, the second contact 104 is disposed radially outwardly to the first contact 102. Further, the first contact 102 and the second contact 104 preferably comprise metal and/or metal alloy.

Further, the first contact region 113 comprises a highly doped first region 112 of the first conductivity type, which is disposed above a first well 114 of the first conductivity type. Further, a second region 116 of the first conductivity type is disposed radially outwardly to the first region 112 and the first well 114. The second contact region 119 comprises a highly doped third region 118 of the second conductivity type disposed above a second well 120 of the second conductivity type.

Preferably, the first conductivity type is an n-type and the second conductivity type is a p-type. Further, the semiconductor substrate 138 is exemplarily chosen as a p-type substrate, which comprises silicon. Thus, in a preferred example the first contact region 113 comprises differently doped regions of an n-type and the second contact region 119 comprises differently doped regions of a p-type.

Further, the second contact region 119 is at least partly surrounded by a trench 136. The trench 136 comprises a doped sidewall of the second conductivity type to advantageously increase the charge transfer efficiency. Thereby, the depth of a doped sidewall of the second conductivity type might increase with a depth of the trench. Alternatively, the doping concentration on the trench side walls is substantially uniform at different depths of the trench.

The trench 136 provides a low path resistance to increase the charge collection efficiency and reduces potential dark noise sources.

Further, a third well 122 of the second conductivity type is preferably arranged below the first contact region 113 and is completely surrounded by the semiconductor substrate 138.

In an advantageous example of the present disclosure, the photosensitive element 100 is a linear mode avalanche photodiode (APD) that is fabricated on bipolar technology. Fabricating the APD on bipolar technology overcomes the drawbacks of the standard CMOS technology, which has a restricted degree of freedom with respect to developing such a detector. This limitation originates from the impossibility of modifying a process flow that has to be optimized for a high performance transistor as well. Further advantages arising from fabricating the APD on bipolar technology are that design requirements as the size of an active area, the distance between the cathode and the anode, and the semiconductor substrate thickness are no limiting factors anymore. Further, also the contact opening of the semiconductor substrate to deposit metal on it can be freely chosen. Further, using the bipolar technology advantageously also provides an APD with a low input impedance. At the same time, a high drive current, speed and gain can be realized.

Incident radiation 125 enters the photosensitive element 100 from a radiation receiving area 139. This radiation receiving area 139 is preferably made from a metal-free material. When a voltage is applied between the first contact 102 and the second contact 104, a multiplication region is formed at the first contact region 113. The applied voltage enhances the electric field around the multiplication region. When incident radiation enters the photosensitive element, it gets absorbed and electron-hole pairs are generated. These charge carriers drift to the multiplication region where the high electric field exists and are multiplied there. When the velocity is the highest, the charge carriers will collide with other atoms and produce new electron-hole pairs. This results in a high photocurrent.

Due to the arrangement of the first contact 102 and the second contact 104 on one side of the photosensitive element 100, the charge that is created due to the incident radiation 125 flows laterally through the photosensitive element 100.

Figure 1 also shows that advantageously either an anti-reflective coating (ARC) or a Bragg filter 132 is arranged below the semiconductor substrate 138. The term "below" denotes a relative term meaning that the ARC or the Bragg filter 132 are arranged at the radiation receiving area 139 of the photosensitive element 100 and are hit by the incident radiation 125 before entering the semiconductor substrate 138. Preferably, between the ARC/the Bragg filter 132 and the semiconductor substrate 138, a highly doped fourth region 128 of the second conductivity type is arranged. The fourth region 128 preferably reduces the contribution of trapped charges or defects point at the side of the photosensitive element where the radiation enters.

Further, below the ARC or below the Bragg filter 132 a glass wafer 134 is placed. The glass wafer 134 is used as the handling component to easy the processing of the photosensitive element 100. The glass handle wafer is removed after the bonding process. Thus, advantageously the incident radiation 125 first enters the ARC or the Bragg filter, then the fourth region 128, and the semiconductor substrate 138.

The ARC as well as the Bragg filter preferably improves the absorption characteristics at a desired wavelength and enables incident radiation to enter the substrate.

Incident radiation 125 that has not been absorbed on the incoming path is reflected by a radiation reflecting area 106 that is disposed in the photosensitive element 100. This radiation reflecting area 106 is arranged on the side opposite to the radiation receiving area 139. Preferably, the radiation reflecting area 106 is arranged on the same side of the photosensitive element 100 as the first contact 102 and the second contact 104. Further, the radiation reflecting area 106 is advantageously arranged substantially centered in the photosensitive element. The first contact 102 advantageously radially surrounds the radiation reflecting area 106. The second contact 104 in turn radially surrounds the first contact 102.

The incident radiation 125 is reflected by the radiation reflecting area 106 resulting in a reflected ray 126. Thus, the incident radiation 125 is substantially reflected back into the multiplication region and the semiconductor substrate 138, where it can be absorbed. The reflection of the incident radiation 125 doubles the effective distance the radiation entails in the photosensitive element. Thus, the present disclosure enables the absorption of radiation with a long wavelengths.

In particular, the reflection of the incident radiation 125 enables that the depth of the semiconductor substrate 138 can be effectively reduced without having an impact on the radiation that can be absorbed. Advantageously, the depth of the semiconductor substrate 138 is chosen to be less than the total absorption depth of wavelength in the red - infrared spectrum. Thus, a particularly compact and small photosensitive element is obtained, which still absorbs long wavelengths.

Providing a photosensitive element with a comparable thin substrate and a radiation reflecting area improves both the speed and the sensitivity of the photosensitive element. Further, the thinned silicon substrate allows a low temperature coefficient and a low breakdown voltage of the photosensitive element, particularly in the near infrared spectral range.

Further, preferably the radiation reflecting area 106 has a diameter D of 230 µm and comprises metal and/or metal alloy. Exemplarily, the radiation reflecting area 106 is made of aluminum.

With a photosensitive element 100 as presented advantageously a peak sensitivity of between 70% and 80% (A/W) for a wavelength at a spectral range of 800 nm - 930 nm can be reached. Advantageously, a peak sensitivity of 73 % (A/W) at a wavelength of 905 nm can be reached. Exemplarily, the sensitivity value can be reached with a thickness of the semiconductor substrate of 30 µm.

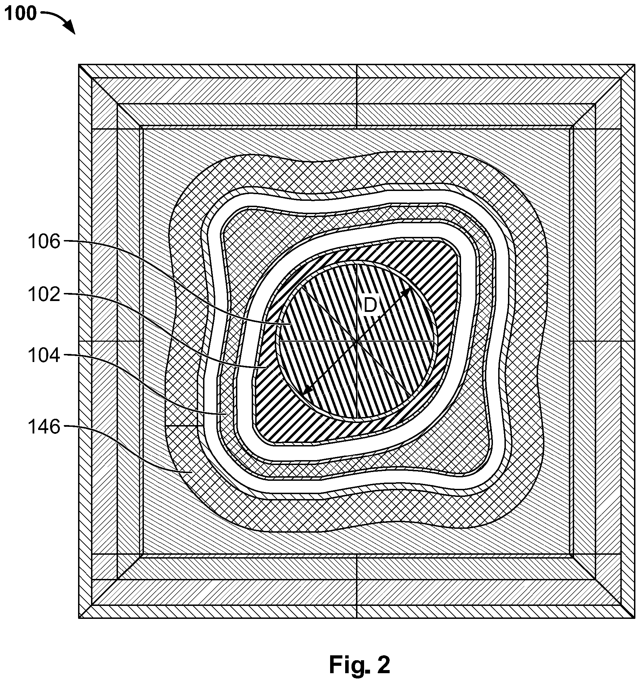

Figure 2 shows a view on the layout of the photosensitive element 100. As can be seen, the radiation reflecting area 106 is preferably placed substantially centered having a diameter of 230 µm. The first contact 102 is positioned radially outwardly thereto. The second contact 104 is placed radially outwardly to the first contact 102 and is electrically separated from the first contact 102. Preferably, radially outwardly to the second contact 104 a channel stopper 146 is arranged.

As shown in Figure 1, the first contact 102 and the second contact 104 are exemplarily electrically separated via a layer 108 that comprises oxide. Exemplarily, multiple layers 108 are separated by a layer 110 comprising nitride.

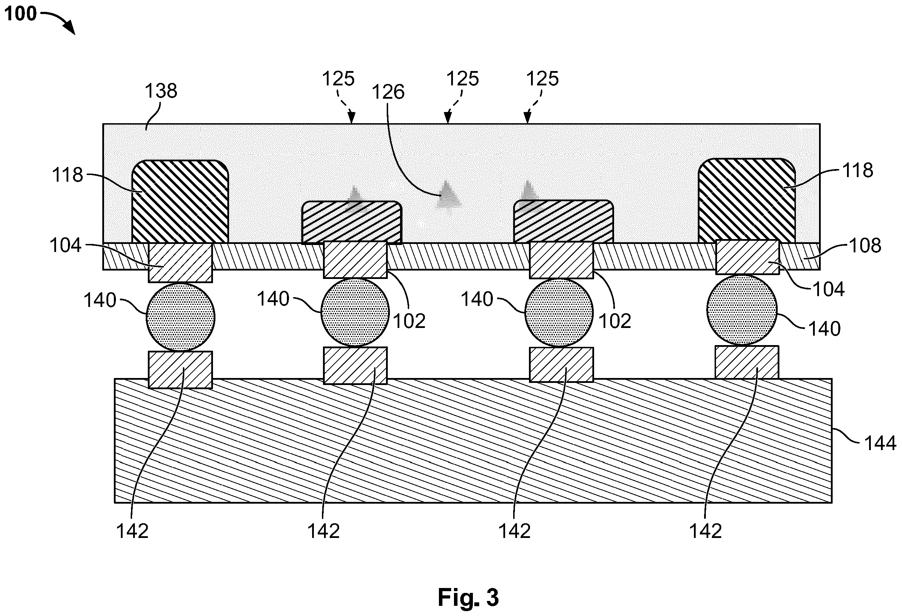

Figure 3 shows the photosensitive element 100 assembled onto a carrier 144. This Figure emphasizes certain advantageous features of the present photosensitive element 100. Having the first contact 102 and the second contact 104 arranged on the same side of the photosensitive element 100, enables it to bond these contacts via flip-chip bonding. Flip-chip bonding is a very reliable and easy-to-integrate bonding method. Via bonding components 140 each contact 102, 104 is bonded with respective bonding parts 142 of the carrier 144. Thereby, the carrier 144 is particularly arranged on the side opposite to the radiation receiving area 139 of the photosensitive element 100.

**List of reference signs**

| **Reference Numeral** | **Description** |
|---|---|
| 100 | Photosensitive element |
| 102 | first contact |
| 104 | second contact |
| 106 | radiation reflecting area |
| 108 | oxide |
| 110 | nitride |
| 112 | first region |
| 113 | first contact region |
| 114 | first well |
| 116 | second region |
| 118 | third region |
| 119 | second contact region |
| 120 | second well |
| 122 | third well |
| 125 | incident radiation |
| 126 | Reflected ray |
| 128 | fourth region |
| 132 | anti-reflective coating/Bragg filter |
| 134 | glass wafer |
| 136 | trench |
| 138 | semiconductor substrate |
| 139 | radiation receiving area |
| 140 | bonding component |
| 142 | bonding component at the carrier |
| 144 | carrier |
| 146 | channel stopper |

## Claims

1. Photosensitive element (100) comprising:
a semiconductor substrate (138) with a radiation receiving area (139), through which incident radiation (125) can enter the photosensitive element (100);
a first contact region (113) connected to a first contact (102) and
a second contact region (119) connected to a second contact (104);
wherein a multiplication region for multiplying charges generated from the incident radiation (125) is formed at the first contact region (113) when a voltage is applied between the first contact (102) and the second contact (104);
wherein the first contact (102) and the second contact (104) are arranged on the side opposite to the radiation receiving area (139) of the semiconductor substrate (138);
wherein a radiation reflecting area (106) is disposed on the side opposite to the radiation receiving area (139) of the semiconductor substrate (138).

2. Photosensitive element (100) according to claim 1, wherein:
the first contact region (113) comprises regions of different conductivity of a first conductivity type and
the second contact region (119) comprises regions of different conductivity of a second conductivity type.

3. Photosensitive element (100) according to one of the claims 1 and 2, wherein
the first contact region (113) comprises a highly doped first region (112) of the first conductivity type disposed above a first well (114) of the first conductivity type and further a second region (116) of the first conductivity type disposed radially outwards to the first region (112) and the first well (114).

4. Photosensitive element (100) according to one of the preceding claims, wherein
the second contact region (119) comprises a highly doped third region (118) of the second conductivity type disposed above a second well (120) of the second conductivity type.

5. Photosensitive element (100) according to one of the preceding claims, wherein
the semiconductor substrate (138) is a p-type substrate and
the first conductivity type is a n-type, and
the second conductivity type is a p-type.

6. Photosensitive element (100) according to one of the preceding claims, wherein
the second contact region (119) is at least partly surrounded by a trench (136)
wherein the trench (136) comprises a doped sidewall of the second conductivity type.

7. Photosensitive element (100) according to one of the preceding claims, wherein
the radiation reflecting area (106) has a diameter D of 230 µm.

8. Photosensitive element (100) according to one of the preceding claims, wherein
an anti-reflective coating, ARC, or a Bragg filter (132) is arranged below the semiconductor substrate (138) at the radiation receiving area (139).

9. Photosensitive element (100) according to one of the preceding claims, wherein
a highly doped fourth region (128) of the second conductivity type is arranged between the semiconductor substrate (138) and the anti-reflective coating or the Bragg filter (132).

10. Photosensitive element (100) according to one of the preceding claims, wherein
the semiconductor substrate (138) comprises silicon.

11. Photosensitive element (100) according to one of the preceding claims, wherein
the photosensitive element (100) is a linear mode avalanche photodiode fabricated on bipolar technology.

12. Photosensitive element (100) according to one of the preceding claims, wherein
the radiation reflecting area (106) comprises metal and/or metal alloy.

13. Photosensitive element (100) according to one of the preceding claims, wherein
the semiconductor substrate (138) has a depth that is less than a total absorption depth of wavelength in the red - infrared spectrum.

14. Photosensitive element (100) according to one of the preceding claims, wherein
a third well (122) of the second conductivity type is arranged below the first contact region (113) and completely surrounded by the semiconductor substrate (138).

15. Photosensitive element (100) according to one of the preceding claims, wherein
the photosensitive element (100) has a peak sensitivity of 73 % (A/W) at a wavelength of 905 nm.

16. Assembly method providing a photosensitive element (100) according to one of the preceding claims, further comprising the step of:
assembling the photosensitive element (100) on a carrier (144),
wherein the carrier (144) is arranged on the side opposite to the radiation receiving area (138) of the photosensitive element (100).
